# EUROPEAN PATENT APPLICATION

(11) **EP 4 621 831 A1**
(43) Date of publication of application: **24.09.2025**
(21) Application number: 23890333.0
(22) Date of filing: 28.08.2023
(51) Int. Cl.: H01L 21/66, H01L 21/67

(54) **ENDPOINT DETECTION APPARATUS AND ION BEAM ETCHING SYSTEM**

(30) Priority: 16.11.2022 CN 202211442526
(71) Applicant: Jiangsu Leuven Instruments Co., Ltd., Xuzhou, Jiangsu 221300 (CN)
(72) Inventor: YIN, Gehua, Xuzhou, Jiangsu 221300 (CN); YAN, Kuicheng, Xuzhou, Jiangsu 221300 (CN); LIU, Haiyang, Xuzhou, Jiangsu 221300 (CN); HU, Dongdong, Xuzhou, Jiangsu 221300 (CN); LI, Xuedong, Xuzhou, Jiangsu 221300 (CN); YANG, Yuxin, Xuzhou, Jiangsu 221300 (CN); JIANG, Zhongyuan, Xuzhou, Jiangsu 221300 (CN); XU, Kaidong, Xuzhou, Jiangsu 221300 (CN)
(74) Representative: Eisenführ Speiser
(86) International application number: PCT/CN2023/115211
(87) International publication number: WO 2024/103895

(57) **Abstract**

An endpoint detection apparatus and an ion beam etching system. The endpoint detection apparatus comprises a mounting bottom plate, an anti-deposition member, a light-transmitting piece, and a detection element. The light-transmitting piece is mounted on the outer side of the mounting bottom plate by means of a fixing member, and the mounting bottom plate is provided with a light-transmitting hole leading to the light-transmitting piece. The anti-deposition member is arranged on the inner side of the mounting bottom plate and extends from the mounting bottom plate in the direction away from the inner side surface of the mounting bottom plate, a light guide channel corresponding to the light-transmitting hole being provided in the anti-deposition member. The detection element is connected to the mounting bottom plate, is located on the outer side of the light-transmitting piece, and corresponds to the light-transmitting piece. The endpoint detection apparatus has an anti-deposition effect, and can effectively prevent particles from being deposited on the light-transmitting piece, thus greatly prolonging the maintenance interval of the light-transmitting piece while not affecting the normal detection function.

## Description

The present application claims the priority to the Chinese Patent Application No. 202211442526.6, titled "ENDPOINT DETECTION DEVICE AND ION BEAM ETCHING SYSTEM", filed on November 16, 2022 with the China National Intellectual Property Administration, which is incorporated herein by reference in its entirety.

### FIELD

The present application relates to the technical field of semiconductor chip manufacturing, and in particular to an endpoint detection device used in a chip ion beam etching system. The present application further relates to an ion beam etching system having the endpoint detection device.

### BACKGROUND

With the development of semiconductor devices, the precision of wafer patterns has continuously improved, leading to the development of a series of dry etching techniques. Commonly applied methods include plasma etching, reactive ion etching, and ion beam etching. The ion beam etching, as a purely physical etching process, is non-selective to materials and can be used to etch almost any solid material, including metals, alloys, oxides, compounds, composite materials, semiconductors, insulators, superconductors, and the like.

During ion beam etching, inert gases such as Ar, Kr, or Xe are filled into an ion source discharge chamber and ionized to form uniform plasma. The ions are then extracted in a beam shape by a grid and accelerated. The ion beam, possessing certain energy, enters the reaction chamber and bombards a surface of the wafer on the stage, causing material atoms to sputter, thereby achieving the etching purpose and obtaining the etched pattern.

In an ion beam etching system, over-etching may damage the next layer of material, while under-etching may affect the subsequent process and cause device failure. Therefore, in the etching process, to selectively and precisely remove material from predetermined areas, real-time monitoring methods are required to control the etching process and the amount of etching.

Endpoint detection is a commonly-used process control method for etching. Other methods include optical emission spectroscopy (OES), laser interferometry, mass spectrometry, and the like. OES is highly sensitive to subtle changes in the film layer, can provide real-time information on various aspects of the etching process, and is easy to integrate with the etching equipment without affecting the etching process, thus it is the most widely used method. The principle is that at the etching endpoint, the intensity of light emitted by specific product groups drops sharply, and product groups formed by the reaction of the underlying film with the plasma start to increase. By monitoring the changes in the intensity of the spectral lines emitted by these groups, endpoint detection is achieved.

In existing ion beam etching systems, OES endpoint detection devices are mostly fixed on the chamber and stationary, such as on the top, the transfer side, or the ion source side. However, due to its relatively long distance from the wafer surface, the intensity of the emission lines received from reactants or products is weak, resulting in poor real-time monitoring performance. Moreover, the light-transmitting piece has poor anti-deposition capability and requires maintenance and upkeep within a short period, failing to meet customer requirements for mean time between cleans (MTBC).

### SUMMARY

An object of the present application is to provide an endpoint detection device to solve the above problems.

Another object of the present application is to provide an ion beam etching system provided with the endpoint detection device.

In order to implement the above objects, an endpoint detection device is provided according to the present application, including a mounting bottom plate, an anti-deposition member, a light-transmitting piece, and a detection element. The light-transmitting piece is mounted on an outer side of the mounting bottom plate by means of a fixing member, and the mounting bottom plate forms a light-transmitting hole leading to the light-transmitting piece. The anti-deposition member is arranged on an inner side of the mounting bottom plate and extends from the mounting bottom plate in a direction away from an inner side surface of the mounting bottom plate, with a light-guiding channel corresponding to the light-transmitting hole being provided in the anti-deposition member. The detection element, located on the outer side of the light-transmitting piece and corresponding to the light-transmitting piece, is connected to the mounting bottom plate.

In an embodiment, the anti-deposition member is provided with a first striped baffle and a second striped baffle at both ends of its light-guiding channel, respectively, and the first striped baffle and the second striped baffle form striped slots, with axial projections of the striped slots of the first striped baffle and the second striped baffle being in a crossed state.

In an embodiment, the striped slots of the first striped baffle and the second striped baffle are striped slots with uneven spacing and/or having different widths.

In an embodiment, the anti-deposition member is provided with plug pieces spaced apart along an axial direction inside its light-guiding channel, and the plug pieces divide the light-guiding channel into multiple inner chambers, with a light-guiding hole being formed in the center of each plug piece.

In an embodiment, the anti-deposition member includes a plug tube. An inner chamber of the plug tube forms the light-guiding channel, and the plug tube is provided with lateral sockets, through which the plug pieces are inserted into the light-guiding channel of the plug tub along the radial direction.

In an embodiment, the plug tube is provided with an outer sleeve, with an annular space formed between the plug tube and the outer sleeve. The plug pieces have a first semi-circular portion that matches an inner diameter of the outer sleeve and a second semi-circular portion that matches an inner diameter of the plug tube, with the diameter of the first semi-circular portion being greater than that of the second semi-circular portion.

In an embodiment, the plug pieces are not evenly distributed, and/or the light-guiding holes of the plug pieces at different positions have different diameters.

In an embodiment, an end of the plug tube is connected to a fixing frame. The fixing frame is used to secure the relative positions of the outer sleeve and the plug tube to keep the plug pieces therebetween.

In an embodiment, a mounting surface of the light-transmitting piece of the mounting bottom plate has an angle deviating from an optical axis.

In an embodiment, an aspect ratio of the light-transmitting hole is greater than or equal to 3, and a depth-to-width ratio of the light-transmitting hole is greater than or equal to 2.

In an embodiment, the outer side of the mounting bottom plate forms a cavity for accommodating the light-transmitting piece, and the light-transmitting piece is located inside the cavity and is fixedly pressed by a fixing cover.

In an embodiment, a light-transmitting piece gasket is provided between the fixing cover and the light-transmitting piece, and/or a sealing ring is provided between the light-transmitting piece and the bottom of the cavity.

In an embodiment, the detection element is mounted on the fixing cover through an adjustment member, and a height adjustment structure is provided between the adjustment member and the fixing cover.

In an embodiment, the height adjustment structure forms an adjustment slot provided in the middle of the fixing cover. The adjustment member is movably embedded in the adjustment slot in an up-and-down direction. Threaded holes are formed at the top and bottom of the fixing cover, with adjustment screws provided in the threaded holes for adjusting the height of the adjustment member.

In an embodiment, the adjustment slot is a rectangular slot, and the adjustment member is of a rectangular block structure. The inner bottom of the adjustment slot is provided with a step portion for supporting the adjustment member, two sides of the adjustment member are limited by the side walls of the adjustment slot, and the adjustment member has the freedom to move up and down within the adjustment slot.

In an embodiment, threaded holes are formed on the sides of the adjustment slot, and fastening screws are provided in the threaded holes, with the fastening screws pressing the adjustment member through the edge of their heads.

In an embodiment, the fixing cover has scale lines, and the adjustment member has indicator lines.

In order to implement another object described above, an ion beam etching system equipped with the endpoint detection device according to any one of the above embodiments is further provided according to the present application. The detection element of the endpoint detection device is connected to a spectrometer through an optical fiber.

In an embodiment, the endpoint detection device is mounted on a lower electrode swing arm of the ion beam etching system.

In an embodiment, the mounting bottom plate of the endpoint detection device constitutes a vacuum sealing plate of the lower electrode swing arm.

In an embodiment, the lower electrode swing arm is fixed to an inner side of a chamber cover of an etching chamber through a magnetic fluid shaft, and the chamber cover is connected to a cavity of the etching chamber through a hinge.

In an embodiment, the optical fiber is routed along a rotation center of the lower electrode swing arm.

The endpoint detection device provided according to the present application places a light-transmitting piece on the outer side of the mounting bottom plate, thus positioning the light-transmitting piece away from the etching environment and preventing it from being excessively exposed thereto. Additionally, a anti-deposition member is mounted on the inner side of the mounting bottom plate, extending away from an inner surface of the bottom plate and forming a light-guiding channel therein. In this way, etch-generated radicals must travel a longer path to reach the light-transmitting piece, effectively preventing deposition and significantly reducing the likelihood of particulate matter settling on the light-transmitting piece. This greatly extends the maintenance cycle of the light-transmitting piece. At the same time, light can pass through the light-guiding channel of the anti-deposition member and the light-transmitting hole of the mounting bottom plate to reach the light-transmitting piece, where it is detected by a detection element, without compromising normal detection functionality.

The ion beam etching system provided according to the present application is equipped with the aforementioned endpoint detection device. Since the endpoint detection device is mounted on the lower electrode swing arm of the ion beam etching system, it is positioned close to the wafer and rotates with it, enabling it to receive stronger emission spectra from reactants or products. Consequently, it effectively enhances the monitoring performance of endpoint detection.

### BRIEF DESCRIPTION OF THE DRAWINGS

FIG. 1 is a schematic exploded view of an endpoint detection device provided according to an embodiment of the present application;
FIG. 2 is a cross-sectional view of the endpoint detection device shown in FIG. 1 after assembly;
FIG. 3 is a partial enlarged view of a light-transmitting hole of a mounting bottom plate shown in FIG. 1;
FIG. 4 is a schematic end view of a height adjustment structure shown in FIG. 1;
FIG. 5 is a schematic structural view of a first striped baffle and a second striped baffle;
FIG. 6 is a schematic structural view of an anti-deposition member provided according to another embodiment;
FIG. 7 is a curve showing the change in light intensity signal within one mean time between cleans (MTBC) cycle after adopting the endpoint detection device provided according to the present application;
FIG. 8 is a schematic partial view of an ion beam etching system provided according to an embodiment of the present application.

Reference numerals in the drawings are as follows:
10 anti-deposition member, 12 first striped baffle, 13 second striped baffle, 14 striped slot, 15 plug tube, 16 base, 17 plug piece, 18 fixing frame, 19 outer sleeve, 20 mounting bottom plate, 21 light-transmitting hole, 22 width of light-transmitting hole, 23 depth of light-transmitting hole, 24 mounting surface of light-transmitting piece, 30 sealing ring, 40 light-transmitting piece, 41 light-transmitting piece gasket, 50 fixing cover, 51 adjustment screw, 52 fastening screw, 53 threaded hole, 54 scale line, 55 indicator line, 60 adjustment member, 70 detection element, 80 optical fiber, 90 spectrometer, 110 cavity, 120 lower electrode assembly, 130 chamber cover, 140 electrostatic chuck, 150 lower electrode swing arm, 160 magnetic fluid shaft, 170 transfer port, 210 wafer center axis, 220 revolving rotation axis.

### DETAILED DESCRIPTION OF THE EMBODIMENTS

In order to provide those skilled in the art with a better understanding of technical solutions of the present application, the present application is described in further detail below in conjunction with the accompanying drawings and specific embodiments.

In this specification, the terms "up, down, inner, outer" are established based on the positional relationship shown in the attached drawings, and the corresponding positional relationship may vary with different attached drawings. Therefore, those terms should not be construed as an absolute limitation of the scope of protection. Moreover, the relationship terminologies such as "first", "second", and the like are only used herein to distinguish one element from another having the same name, rather than to necessitate or imply that the actual relationship or order exists between the elements.

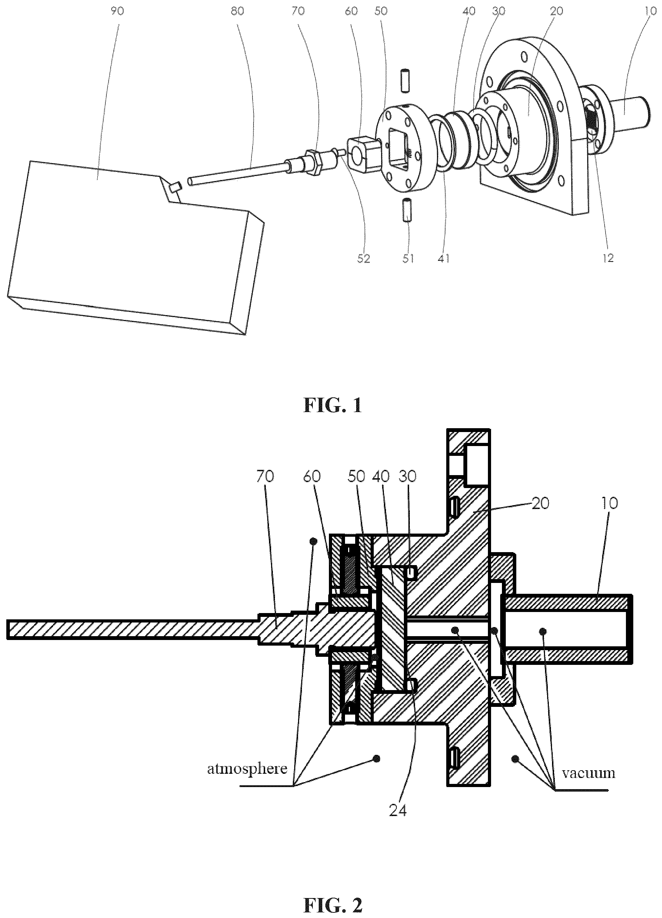

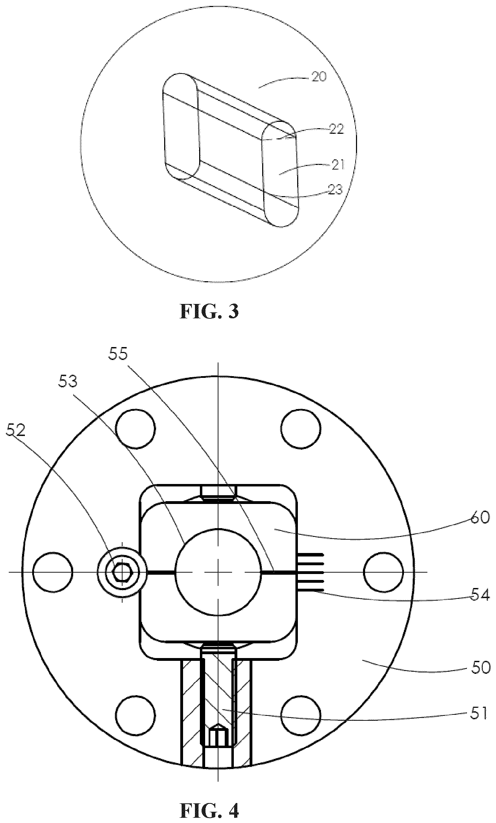

References are made to FIGS. 1 to 3. FIG. 1 is a schematic exploded view of an endpoint detection device provided according to an embodiment of the present application, FIG. 2 is a cross-sectional view of the endpoint detection device shown in FIG. 1 after assembly, and FIG. 3 is a partial enlarged view of a light-transmitting hole of a mounting bottom plate shown in FIG. 1.

As shown in the figure, in a specific embodiment, the endpoint detection device provided according to the present application mainly consists of an anti-deposition member 10, a mounting bottom plate 20, a sealing ring 30, a light-transmitting piece 40, a fixing cover 50, an adjustment member 60, a detection element 70, an optical fiber 80, and a spectrometer 90.

The mounting bottom plate 20 is generally of a flange shape, with an upper half of its flange edge being semicircular and a lower half rectangular, to match the shape of the mounting position. The light-transmitting piece 40 is mounted on an outer side of the mounting bottom plate 20 via the fixing cover 50. The mounting bottom plate 20 forms a light-transmitting hole 21 leading to the light-transmitting piece 40, which is fully covered by the light-transmitting piece 40. The anti-deposition member 10 is in a cylindrical shape, with a flange provided at one end, and the anti-deposition member 10 is mounted on an inner side of the mounting bottom plate 20 through the flange. The anti-deposition member 10 is of a certain length, extending from the mounting bottom plate 20 in a direction away from an inner surface of the mounting bottom plate. A light-guiding channel corresponding to the light-transmitting hole 21 is formed inside the anti-deposition member 10.

The detection element 70 is connected to the mounting bottom plate 20, located on the outer side of the light-transmitting piece 40, and directly facing a central area of the light-transmitting piece 40. The detection element 70 is connected to the spectrometer 90 via the optical fiber 80 to transmit optical signals to the spectrometer 90.

In practical use, the fixing cover 50, the adjustment member 60, the detection element 70, and the outer side of the mounting bottom plate 20 are exposed to the atmospheric environment, while the anti-deposition member 10, the mounting bottom plate 20, and the inner side of the mounting bottom plate 20 are in a vacuum environment.

The outer side of the mounting bottom plate 20 forms a circular cavity for accommodating the light-transmitting piece 40, which is located inside the cavity and pressed and fixed by the fixing cover 50.

The light-transmitting piece 40 serves as a sealing and stress-bearing member between the vacuum and the atmosphere. To prevent damage from excessive compression, a soft light-transmitting piece gasket 41 is placed between the fixing cover 50 and the light-transmitting piece 40. The material of the light-transmitting piece 40 may be quartz or sapphire, depending on the process requirements, while the material of the light-transmitting piece gasket 41 may be PP (polypropylene) or PTFE (polytetrafluoroethylene).

A sealing ring 30 is placed between the light-transmitting piece 40 and the bottom of the cavity. The fixing cover 50 presses the light-transmitting piece 40 by bolts mounted on the mounting bottom plate 20, thereby squeezing the sealing ring 30 to achieve sealing.

The mounting surface of the light-transmitting piece 40 has an angle deviating from the optical axis. In other words, by changing the design angle of a mounting surface 24 of the light-transmitting piece on the mounting bottom plate 20, the center of the detection element 70 can be made parallel to or at an angle to the wafer surface.

The light-transmitting hole 21 on the mounting bottom plate 20 is designed as a narrow and deep slit with a flat, oblong cross-section. The length-to-width ratio of the light-transmitting hole 21 is greater than or equal to 3, and the depth-to-width ratio is greater than or equal to 2, that is, the ratio of the depth 23 to the width 22 shown in the figure is greater than or equal to 2, so as to achieve the purpose of preventing deposition.

The endpoint detection device may use OES to achieve the endpoint detection function, relying on the spectrometer 90 to convert the detected optical signals from the ion beam etching chamber into analog electrical signals for output.

To detect the optical signals, the center of the detection element 70 must be higher than the upper surface of the wafer, and the height difference directly affects the intensity of the optical signals. Therefore, an easily adjustable height structure is provided between the adjustment member 60 and the fixing cover 50.

With reference to FIG. 4, FIG. 4 is a schematic end view of a height adjustment structure shown in FIG. 1.

As shown in the figure, the detection element 70 is mounted on the fixing cover 50 via an adjustment member 60, and a height adjustment structure is provided between the adjustment member 60 and the fixing cover 50.

Specifically, the adjustment member 60 is a block structure with a square axial projection. A rectangular adjustment slot is formed in the center of the fixing cover 50. The transverse width of the rectangular adjustment slot is roughly equivalent to the transverse width of the adjustment member 60, and the longitudinal length of the rectangular adjustment slot is greater than the longitudinal length of the adjustment member 60. A step section (i.e., a section that is not fully penetrated) for supporting the adjustment member 60 is provided on the inner bottom of the adjustment slot. Both sides of the adjustment member 60 are limited by the side walls of the adjustment slot, preventing the adjustment member 60 from moving in a left-right direction, but allowing it to move up and down freely within the adjustment slot. When the adjustment member 60 is inserted into the adjustment slot, it can move up and down in the slot. Threaded holes are formed on the top and bottom of the fixing cover 50, and adjustment screws 51 for adjusting the height of the adjustment member 60 are provided in these threaded holes.

Threaded holes are also formed on the sides of the adjustment slot, and fastening screws 52 are provided in these holes to press tightly against the adjustment member 60 with the edges of their heads.

The fixing cover 50 has multiple scale lines 54, symmetrically and evenly distributed around the center. The adjustment member 60 has only one indicator line 55, which serves as a pointer for easy visual adjustment. When height is needed to be adjusted, the two upper and lower adjustment screws 51 are turned, and the adjustment member 60 can be fixed at a desired position based on the indication of the indicator line 55. Then, the fastening screws 52 are tightened to fully secure the adjustment member 60 to the fixing cover 50, thereby completing the height adjustment. In the initial design, the adjustment member 60 is positioned at the center of the fixing cover 50, with a 2mm adjustment range both in up and down directions.

The detection element 70 is provided with external threads, and a through threaded hole 53 is formed in the center of the adjustment member 60. The detection element 70 is connected to the adjustment member 60 via threads, and the detection element 70 may be directly screwed into the threaded hole 53 of the adjustment member 60, allowing the detection element 70 to move together with the adjustment member 60.

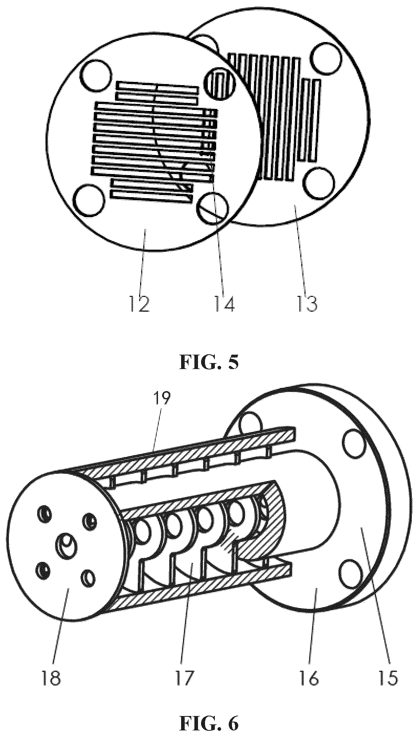

With reference to FIG. 5, FIG. 5 is a schematic structural view of a first striped baffle and a second striped baffle.

In another embodiment, the anti-deposition member 10 is provided with a first striped baffle 12 and a second striped baffle 13 at both ends of its light-guiding channel, respectively. The first striped baffle 12 and the second striped baffle 13 are provided with equally spaced and equally width striped slots 14 starting from the center, and the axial projections of the striped slots 14 on both are in a crossed state. In this embodiment, the axial projections of the striped slots 14 on the first striped baffle 12 and the second striped baffle 13 are perpendicular to each other, with the baffle strips in a 90 degrees crossed state.

Also, in other embodiments, the striped slots 14 on the first striped baffle 12 and the second striped baffle 13 may also be unevenly spaced and/or have different widths.

By adding the first striped baffle 12 and the second striped baffle 13 at both ends of the anti-deposition member 10, the reactants or products pass through the striped slots 14 before reaching the light-transmitting piece 40, and preferentially deposit on the baffle strips forming the striped slots 14, thereby reducing the deposition amount on the light-transmitting piece 40 and further improving the anti-deposition effect.

With reference to FIG. 6, FIG. 6 is a schematic structural view of an anti-deposition member provided according to another embodiment.

In yet another embodiment, the anti-deposition member 10 is provided with plug pieces 17 spaced apart along the axial direction inside its light-guiding channel. These plug pieces 17 divide the light-guiding channel of the anti-deposition member 10 into multiple spaced-apart inner cavities, and coaxial light-guiding holes are formed in the center of the plug pieces 17.

Specifically, the main part of the anti-deposition member 10 is a plug tube 15, and the inner chamber of the plug tube 15 forms the light-guiding channel. The plug tube 15 is provided with a lateral socket, and the plug pieces 17 are inserted into the light-guiding channel of the plug tube 15 in the radial direction from the lateral socket.

An outer sleeve 19 is mounted outside the plug tube 15, with an annular space formed between the two. The plug piece 17 has a first semi-circular portion that matches the inner diameter of the outer sleeve 19 and a second semi-circular portion that matches the inner diameter of the plug tube 15. The diameter of the first semi-circular portion is larger than that of the second semi-circular portion. The plug piece 17 divides the light-guiding channel into multiple inner chambers through the second semi-circular portion and part of the first semi-circular portion, while the remaining annular part of the first semi-circular portion is located in the annular space between the plug tube 15 and the outer sleeve 19.

The spacing between the plug pieces 17 may vary, and the diameters of the light-guiding holes in the plug pieces 17 at different positions may also differ.

One end of the plug tube 15 is equipped with a base 16, and the other end of the plug tube 15 is connected to a fixing frame 18, which is of a disc shape and fixed to the end of the plug tube 15 with screws. This compresses the outer sleeve 19 against the base 16, securing the position of the outer sleeve 19 relative to the plug tube 15 and simultaneously positioning multiple plug pieces 17.

By placing the plug pieces 17 in the light-guiding channel of the anti-deposition member 10, reactants or products first pass through the various inner chambers formed by the plug pieces 17 before reaching the light-transmitting piece 40, preferentially depositing in these inner chambers. This reduces the amount of deposition on the light-transmitting piece 40, effectively preventing particulate matter from settling on it and further enhancing the anti-deposition effect.

The aforementioned four anti-deposition structures (light-transmitting holes, light-guiding channels, striped baffles, and plug pieces) may be used individually or in combination to prevent particulate matter from depositing on the light-transmitting piece 40.

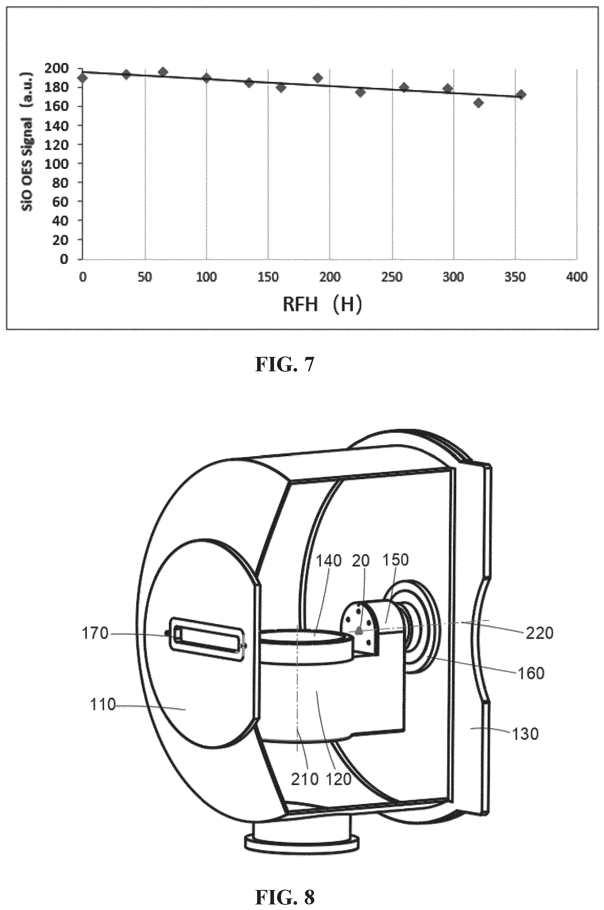

The design of the anti-deposition structures in this endpoint detection device effectively prevents particulate matter from depositing on the light-transmitting piece 40. Relevant experiments conducted demonstrate that, after using the endpoint detection device described above, there is no significant attenuation of the light intensity signal within one MTBC cycle (see FIG. 7), significantly extending the maintenance interval for the light-transmitting piece 40.

Furthermore, this endpoint detection device is easy to mount and adjust, offering excellent practical application results.

The above embodiments are only preferred solutions of the present application, and the present application is not specifically limited thereto. On this basis, targeted adjustments can be made according to actual needs, thereby obtaining different embodiments. For example, the mounting surface of the anti-deposition member 10 may have an inner chamber, forming a vacuum chamber with its diameter larger than that of its light-guiding channel with the mounting bottom plate 20, or the mounting bottom plate 20 may be designed in other shapes. Since there are many implementations, no more examples are taken and illustrated here.

As shown in FIG. 8, in addition to the aforementioned endpoint detection device, an ion beam etching system is further provided according to the present application. The system is provided with the endpoint detection device as described above. The detection element 70 of the endpoint detection device is connected to a spectrometer 90 via an optical fiber 80.

Specifically, the endpoint detection device is mounted on a lower electrode swing arm 150 of the ion beam etching system and is integrated with the lower electrode swing arm 150, and the mounting bottom plate 20 of the endpoint detection device serves as a vacuum sealing plate for the lower electrode swing arm 150. This allows the detection element 70 to be away from a transfer port 170 with a distance less than 300mm from the central axis 210 of the wafer, and capable of revolving with the wafer but not rotating with it.

The lower electrode swing arm 150 is fixed to an inner surface of a chamber cover 130 of the etching chamber via a magnetic fluid shaft 160. The chamber cover 130 is connected to a cavity 110 of the etching chamber via hinges, allowing the cavity 110 to open with the chamber cover 130, facilitating easy installation and providing ample maintenance space.

During use, the wafer is adsorbed onto the lower electrode assembly 120 by an electrostatic chuck 140 and rotates around the central axis 210 of the wafer. The lower electrode assembly 120 is fixed to the lower electrode swing arm 150 and revolves around a revolution rotation axis 220 along with the wafer.

The optical fiber 80 is routed through the rotation center of the lower electrode swing arm 150 and secured with fixtures, preventing it from revolving and thus protecting the optical fiber and extending its lifespan.

Since the endpoint detection device is mounted on the lower electrode swing arm 150 of the ion beam etching system, it is positioned close to the wafer and revolves with it, receiving stronger emission lines from reactants or products. Therefore, it effectively enhances the monitoring performance of endpoint detection.

Remaining structures of the ion beam etching system may be referred to the conventional technology, which will not be repeated herein.

The endpoint detection device and the ion beam etching system provided according to the present application have been described in detail above. The principle and implementations of the present application are described herein by using specific examples, and the description of the above embodiments is only used to help understand the core idea of the present application. It should be noted that, several improvements and modifications may be made by those skilled in the art to the present application without departing from the principle of the present application, and these improvements and modifications also fall within the protection scope of the claims of the present application.

## Claims

1. An endpoint detection device, comprising a mounting bottom plate (20), an anti-deposition member (10), a light-transmitting piece (40), and a detection element (70), wherein
the light-transmitting piece (40) is mounted on an outer side of the mounting bottom plate (20) via fixing members, and the mounting bottom plate (20) forms a light-transmitting hole (21) leading to the light-transmitting piece (40);
the anti-deposition member (10) is disposed on an inner side of the mounting bottom plate (20) and extends away from an inner surface of the mounting bottom plate (20), with a light-guiding channel corresponding to the light-transmitting hole (21) provided in the anti-deposition member (10); and
the detection element (70) is connected to the mounting bottom plate (20) and is located on the outer side of the light-transmitting piece (40) corresponding to the light-transmitting piece (40).

2. The endpoint detection device according to claim 1, wherein the anti-deposition member (10) is provided with a first striped baffle (12) and a second striped baffle (13) at both ends of the light-guiding channel, respectively, and the first striped baffle (12) and the second striped baffle (13) form striped slots (14), with axial projections of the striped slots (14) of the two being in a crossed state.

3. The endpoint detection device according to claim 2, wherein the striped slots (14) of the first striped baffle (12) and the second striped baffle (13) are striped slots with uneven spacing and/or having different widths.

4. The endpoint detection device according to claim 1, wherein the anti-deposition member (10) is provided with plug pieces (17) spaced apart along an axial direction inside its light-guiding channel, and the plug pieces (17) divide the light-guiding channel into a plurality of inner chambers, with a light-guiding hole formed in a center of each plug piece (17).

5. The endpoint detection device according to claim 4, wherein the anti-deposition member (10) comprises a plug tube (15); and wherein
an inner chamber of the plug tube (15) forms the light-guiding channel, and the plug tube (15) is provided with lateral sockets, through which the plug pieces (17) are inserted into the light-guiding channel of the plug tube (15) along the radial direction.

6. The endpoint detection device according to claim 5, wherein the plug tube (15) is provided with an outer sleeve (19), with an annular space formed between the plug tube (15) and the outer sleeve (19); and
the plug pieces (17) have a first semi-circular portion that matches an inner diameter of the outer sleeve (19) and a second semi-circular portion that matches an inner diameter of the plug tube (15), with the diameter of the first semi-circular portion being greater than that of the second semi-circular portion.

7. The endpoint detection device according to claim 6, wherein the plug pieces (17) are distributed unevenly, and/or the light-guiding holes of the plug pieces (17) at different positions have different diameters.

8. The endpoint detection device according to claim 7, wherein an end of the plug tube (15) is connected to a fixing frame (18); and wherein
the fixing frame (18) is used to secure the relative positions of the outer sleeve (19) and the plug tube (15) to keep the plug pieces (17) therebetween.

9. The endpoint detection device according to any one of claims 1 to 8, wherein a mounting surface (24) of the light-transmitting piece of the mounting bottom plate (20) has an angle deviating from an optical axis.

10. The endpoint detection device according to any one of claims 1 to 8, wherein an aspect ratio of the light-transmitting hole (21) is greater than or equal to 3, and a depth-to-width ratio of the light-transmitting hole (21) is greater than or equal to 2.

11. The endpoint detection device according to any one of claims 1 to 8, wherein the outer side of the mounting bottom plate (20) forms a cavity for accommodating the light-transmitting piece (40), and the light-transmitting piece (40) is located inside the cavity and is fixedly pressed by a fixing cover (50).

12. The endpoint detection device according to claim 11, wherein a light-transmitting piece gasket (41) is provided between the fixing cover (50) and the light-transmitting piece (40); and/or
a sealing ring (30) is provided between the light-transmitting piece (40) and the bottom of the cavity.

13. The endpoint detection device according to claim 12, wherein the detection element (70) is mounted on the fixing cover (50) through an adjustment member (60), and a height adjustment structure is provided between the adjustment member (60) and the fixing cover (50).

14. The endpoint detection device according to claim 13, wherein the height adjustment structure comprises an adjustment slot provided in the middle of the fixing cover (50), the adjustment member (60) is movably embedded in the adjustment slot in an up-and-down direction, and threaded holes are provided at the top and bottom of the fixing cover (50), with adjustment screws (51) provided in the threaded holes for adjusting the height of the adjustment member.

15. The endpoint detection device according to claim 14, wherein the adjustment slot is a rectangular slot, and the adjustment member (60) has a rectangular block structure; and wherein
an inner bottom of the adjustment slot is provided with a step portion for supporting the adjustment member (60), the two sides of the adjustment member (60) are limited by the side walls of the adjustment slot, and the adjustment member (60) has the freedom to move up and down within the adjustment slot.

16. The endpoint detection device according to claim 15, wherein threaded holes are provided on the sides of the adjustment slot, and fastening screws (52) are provided in the threaded holes, with the fastening screws (52) pressing the adjustment member (60) through the edge of their heads.

17. The endpoint detection device according to claim 13, wherein the fixing cover (50) has scale lines (54), and the adjustment member (60) has indicator lines (55).

18. An ion beam etching system equipped with the endpoint detection device according to any one of claims 1 to 17, and the detection element (70) of the endpoint detection device is connected to a spectrometer (90) through an optical fiber (80).

19. The ion beam etching system according to claim 18, wherein the endpoint detection device is mounted on a lower electrode swing arm (150) of the ion beam etching system.

20. The ion beam etching system according to claim 19, wherein the mounting bottom plate (20) of the endpoint detection device constitutes a vacuum sealing plate of the lower electrode swing arm (150).

21. The ion beam etching system according to claim 19, wherein the lower electrode swing arm (150) is fixed to an inner side of a chamber cover (130) of an etching chamber through a magnetic fluid shaft (160), and the chamber cover (130) is connected to a cavity (110) of the etching chamber through a hinge.

22. The ion beam etching system according to claim 19, 20, or 21, wherein the optical fiber (80) is routed along a rotation center of the lower electrode swing arm (150).
